# EUROPEAN PATENT SPECIFICATION

(11) **EP 2 458 830 B1**
(45) Date of publication and mention of the grant of the patent: **20.03.2013**
(21) Application number: 12156953.7
(22) Date of filing: 13.11.2009
(51) Int. Cl.: H04M 1/23, H04M 1/67, G06F 3/02, G06F 3/023, G06F 1/16, G06F 3/044

(54) **Detection of intended key activation on a mobile device**
Erkennung der beabsichtigten Tastenaktivierung auf einer mobilen Vorrichtung
Détection d'activation d'une touche prévue dans un dispositif mobile

(43) Date of publication of application: 30.05.2012
(62) Divisional of application: 09175999.3
(73) Proprietor: Research In Motion Limited, Waterloo, ON N2L 3W8 (CA)
(72) Inventor: Werner, Colin, Waterloo, Ontario N2L 5Z5 (CA); Kuhl, Lawrence Edward, Waterloo, Ontario N2L 5Z5 (CA); Marui, Keizo, Waterloo, Ontario N2L 5Z5 (CA); Chen, Chao, Waterloo, Ontario N2L 3W8 (CA); Wu, Ken, Waterloo, Ontario N2L 3W8 (CA)
(74) Representative: Moore, Barry

(56) References cited:
- EP-A2- 1 109 382
- EP-A2- 1 832 963
- US-A1- 2007 256 915
- US-A1- 2008 085 743
- US-A1- 2009 008 234

## Description

The present application relates generally to mobile devices. More particularly, the present application relates generally to the prevention of unintended key presses, which result in actuation or activation of the key.

Mobile devices provide users with convenient functions and capabilities relating to communication and organization. Accordingly, many users carry their mobile device with them in a pocket, purse, holster, or other means. It is desirable for a user to keep a mobile device turned on at all times in order to take full advantage of its functionality.

Hard keys on a mobile device can accidently be pushed or actuated while the device is being transported by a user, or when inserted/removed from a carrying case or holster. Users often keep a mobile device keyboard unlocked to permit easy access to the device features, without having to unlock the device for each use. Even when keyboard input is temporarily disabled or locked, some mobile devices permit access to certain functions such as making an emergency call or answering an incoming call.

Accidental actuation of a hard key can have unintended results, such as launching an application or dialing a phone number that was not desired. This can lead a user to believe that the mobile device is not functioning properly, and lead to annoyance or frustration.
US 2007/256915 A1 discloses a touch-sensitive input device having an exposed, continuous surface defining a planar area, and a grid of sense elements coextensive with the area of the exposed surface and responsive to engagement of the exposed surface by an operator to establish a position of said engagement of the exposed surface.
EP 1 109 382 A2 relates to a terminal for a communication system. The terminal comprises detector means that are arranged to detect if there is a contact between at least one surface of the terminal and the skin of the user of the terminal. The detection means comprise at least two different detector arrangements for detecting a contact between the terminal and the user. The detector arrangements each comprise independently operated sensor means.

### GENERAL

Generally, the present application may provide a method and device for preventing unintended activation of one or more keys on a mobile device. By measuring a capacitance level at the mobile device keypad, a determination may be made to distinguish between a human touch and abutment with an object. A capacitive sensor may sense a capacitance level at a location on the keyboard, to detect whether a hard key is being actuated by a human hand or human skin. If the sensed capacitance level exceeds a key activation capacitance threshold, a key circuit connection is identified as being associated with an intended hard key activation. If the measured capacitance level is within an uncertainty tolerance below the key activation capacitance threshold, a secondary capacitance level may be measured at a non-keyboard location. The key circuit connection may be identified as being associated with an intended hard key activation when the measured secondary capacitance level exceeds a key activation confirmation threshold. Additional secondary indicators can be obtained based on size and shape capacitance pattern, timing information, and an active application or device state.

In an embodiment, the present application may provide a mobile device comprising a keyboard, a printed circuit board (PCB), a capacitive sensor and a processor. The keyboard comprises a keypad defining a plurality of hard keys. The PCB comprises a plurality of key circuits to detect actuation of the plurality of hard keys. The capacitive sensor may be provided between the keypad and the printed circuit board and arranged to detect a capacitance level on the keypad. The processor may be arranged to identify an intended hard key activation in response to receiving an indication of connection of one of the plurality of key circuits, and when a detected capacitance level on the keypad exceeds a key activation capacitance threshold.

The mobile device can further comprise a light shielding capacitive sensing film providing back light shielding and capacitance detection. The capacitive sensor can be provided on a surface of the light shielding capacitive sensing film. The capacitive sensor provided on the light shielding capacitive sensing film can be implemented by way of a conductive coating. The conductive coating can comprise an x-channel coating provided on one side of the light shielding capacitive sensing film, and a y-channel coating provided on another side of the light shielding capacitive sensing film. In an embodiment, the x-channel coating is provided on a keyboard-facing side of the light shielding capacitive sensing film, and the y-channel coating is provided on a PCB-facing side of the light shielding capacitive sensing film.

The mobile device can further comprise a housing, and a secondary capacitive sensor disposed at a non-keyboard location on the mobile device and arranged to detect a secondary capacitance level at the non-keyboard location. The non-keyboard location can be a location on an outer face of the housing. The processor can be arranged to compare the measured secondary capacitance level at the non-keyboard location to a key activation confirmation threshold, and to identify the key circuit connection as being associated with an intended hard key activation when the measured secondary capacitance level exceeds the key activation confirmation threshold.

In an example, the key activation capacitance threshold can be about 2 pico Farads greater than a base capacitance, the base capacitance being measured in the absence of actuation of one of the plurality of hard keys by human skin.

In another embodiment, the present disclosure may provide a method of identifying an intended hard key actuation on a mobile device. The mobile device may have a keyboard including a keypad defining a plurality of hard keys, and a printed circuit board including a plurality of key circuits to detect actuation of the plurality of hard keys. The method may comprise the following steps: receiving an indication of connection of a selected one of the plurality of key circuits associated with a selected one of the plurality of hard keys; obtaining a measured capacitance level at a keyboard location near the selected hard key; comparing the measured capacitance level at the keyboard location to a key activation capacitance threshold; and identifying the key circuit connection as being associated with an intended hard key activation when the measured capacitance level exceeds the key activation capacitance threshold.

The method can further comprise intercepting the key circuit connection before an associated input is passed to an active application. The method can further comprise processing an input associated with the actuation of the selected hard key.

In another embodiment, the present application may provide a computer-readable medium storing statements and instructions for execution by a processor to perform the method of identifying an intended hard key actuation on the mobile device as described herein.

If the measured capacitance level is within an uncertainty tolerance below the key activation capacitance threshold, the method can further comprise the following steps: obtaining a measured secondary capacitance level at a non-keyboard location of the mobile device; comparing the measured secondary capacitance level at the non-keyboard location to a key activation confirmation threshold; and identifying the key circuit connection as being associated with an intended hard key activation when the measured secondary capacitance level exceeds the key activation confirmation threshold.

### BRIEF DESCRIPTION OF THE DRAWINGS

Embodiments will now be described, by way of example only, with reference to the attached Figures, wherein:

Figure **1** illustrates a block diagram of a mobile device arranged to identify an intended key activation according to an embodiment of the present application.

Figure **2** is a flowchart illustrating a method of identifying an intended key activation on a mobile device according to an embodiment of the present application.

Figure **3** illustrates an exploded view of elements of a mobile device according to an embodiment of the present application including a capacitive sensor provided on a light shielding film.

Figure **4** illustrates a top view of the light shielding film having a capacitive sensor as shown in Figure **3****.**

Figure **5** illustrates a bottom view of the light shielding film having a capacitive sensor as shown in Figure **3****.**

Figure **6** illustrates a block diagram of a mobile device arranged to identify an intended key activation according to another embodiment of the present application.

Figure **7** is a flowchart illustrating a method of identifying an intended key activation on a mobile device according to another embodiment of the present application.

Figures **8, 9****,** **10** and **11** illustrate a mobile device including secondary capacitive sensors according to an embodiment of the present application.

Figure **12** is a block diagram of a mobile electronic device according to one example.

### DESCRIPTION OF PREFERRED EMBODIMENTS

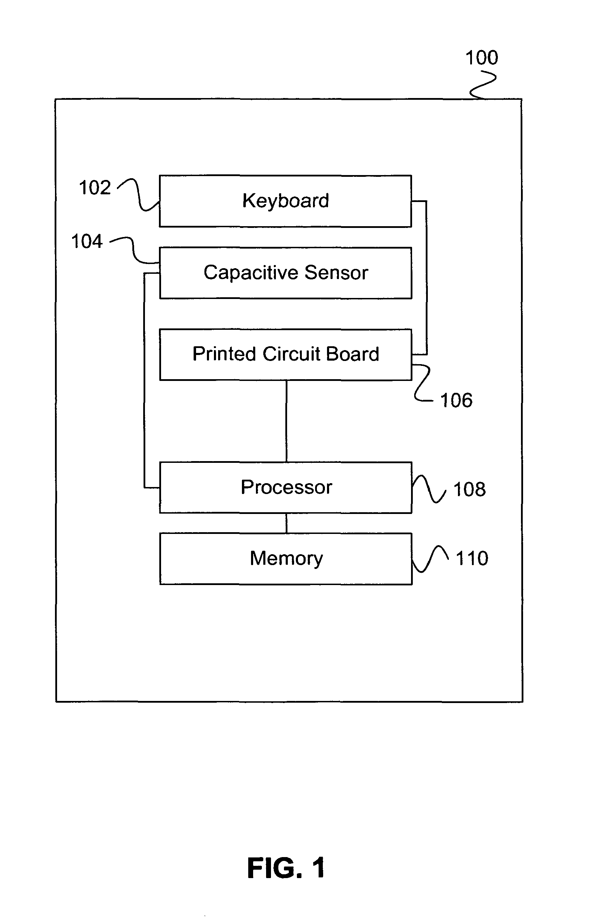

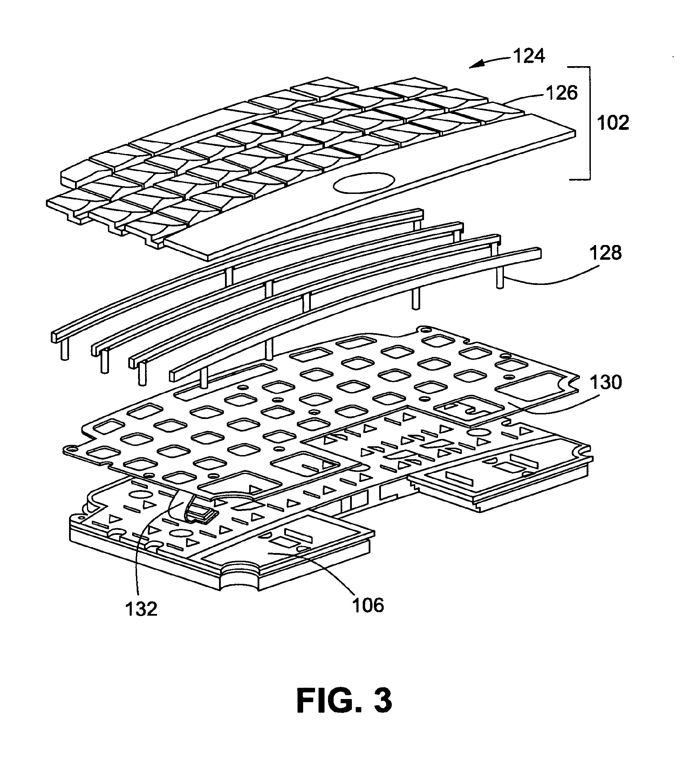

Figure **1** illustrates a block diagram of a mobile device arranged to identify an intended key activation according to an embodiment of the present application. The mobile device **100** includes a keyboard **102,** a capacitive sensor **104,** and a printed circuit board (PCB) **106.** As illustrated with respect to Figure **3****,** the keyboard **102** includes a keypad **124** defining a plurality of hard keys, or key caps, **126.** Referring back to Figure **1****,** the printed circuit board **106** includes a plurality of key circuits to detect actuation of the plurality of hard keys. The capacitive sensor **104** is provided between the keypad of the keyboard **102** and the printed circuit board (PCB) **106** and is arranged to detect a capacitance level on the keypad. Some known approaches provide a layer of capacitive film on the keypad, but this is for gesture-based navigation or identification of finger moving, not for addressing the issue of keys accidental activation.

The capacitive sensor **104** senses a change in capacitance between the sensor and ground. In embodiments described herein, the capacitive sensor is used to distinguish between intended and unintended key activations. This is based on the understanding that an intended key activation will be the result of human skin touching the keyboard **102,** such as by typing with a user's fingers or thumbs. Capacitive sensing does not require direct contact. For example, a capacitive sensor used with a touch screen device can be provided underneath a glass surface of a display and still provide capacitive sensing capabilities. In an embodiment, the capacitive sensor **104** can sense if a human finger is within about 1 mm of the sensor. Most capacitive sensors cannot sense a change in capacitance if the finger is more than about 2mm away from the sensor.

The mobile device **100** further includes a processor **108** arranged to identify an intended hard key activation. In known mobile devices, a processor identifies a hard key activation based simply on a corresponding key circuit on the PCB being connected. The processor **108** is arranged to identify an intended hard key activation in response to receiving an indication of connection of a key circuit, and when a detected capacitance level on the keypad exceeds a key activation capacitance threshold. According to an embodiment, after detecting connection of a key circuit, the basic determination performed is whether the measured capacitance is high enough above the base, or unactivated, capacitance level to trigger an intended key activation determination. This capacitance level is referred to herein as a key activation capacitance threshold.

In an embodiment, a memory **110,** such as a computer-readable memory, is in communication with the processor **108** and stores statements and instructions for execution by the processor to identify an intended hard key activation in response to receiving an indication of connection of a key circuit, and when a detected capacitance level on the keypad exceeds a key activation capacitance threshold.

The capacitive sensor **104** can measure a capacitive difference and profile the measured value with respect to a stored base capacitance, the base capacitance being the capacitive difference measured in the absence of actuation of a key by human skin. The key activation capacitance threshold can be defined as the sum of the base capacitance and a human touch capacitance value. In an example, the key activation capacitance threshold can be defined in relative terms as being about 2 picofarads greater than the base capacitance, where the human touch capacitance value is about 2 picofarads. In other words, when a human finger is present, the capacitance change, or difference, is about 2 pF in this example. The value of the human touch capacitance value may be lower if the insulation layer is thicker.

An advantage of positioning the capacitive sensor **104** below the keycaps **126** and above the PCB **106** is mechanical integrity. Such a positioning provides a more durable implementation, as the capacitive sensor is protected and would not wear down as quickly. In an embodiment, the capacitive sensor film is provided close to the keycaps to yield improved sensing capability.

If the capacitive sensor **104** is provided on top of the keypad, the shape of the hard keys may need to be changed. In an embodiment, the capacitive sensor can comprise a separate capacitive sensor on each key. Alternatively, the entire keypad surface could be constructed with a capacitance capability.

The capacitive sensor **104** can be designed to detect a location of human touch within a particular area on the keyboard **102.** Different sensor designs and sensitivities can be used depending on the desired accuracy of touch identification. For example, the capacitive sensor **104** can include a single capacitive pad to detect the presence of a human finger, or human skin. In an embodiment, the capacitive sensor **104** can include a plurality of capacitive sensors arranged to detect the presence of a human finger or human skin, and to provide a secondary indicator, which will be described later in detail. In an example, the capacitive sensor **104** can include a 2x3 matrix of capacitive pads. In an embodiment, touch location accuracy can be secondary to a simple detection of a human finger touching the keypad somewhere.

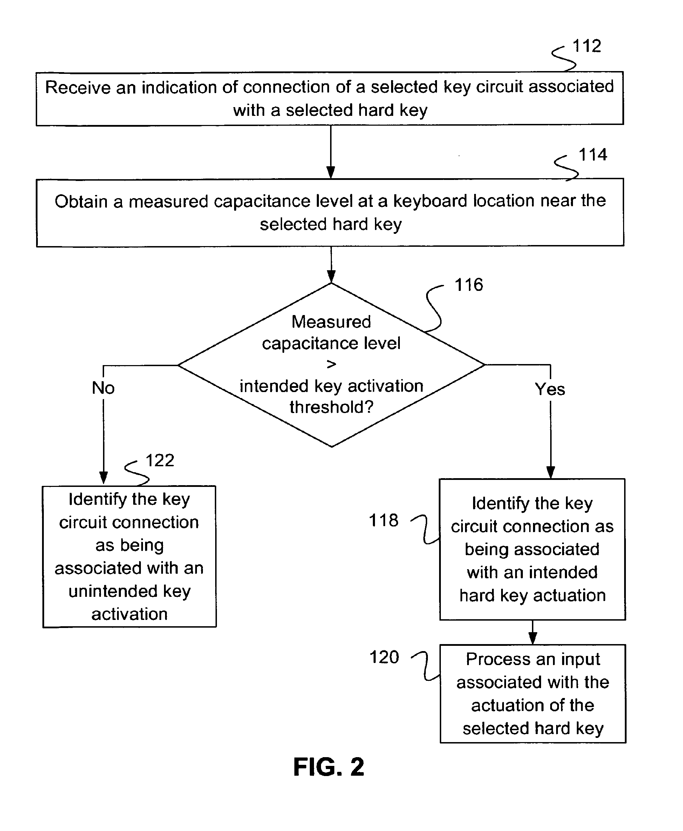

Figure **2** is a flowchart illustrating a method of identifying an intended key activation on a mobile device according to an embodiment of the present application. As discussed above, the mobile device **100** has a keyboard **102** including a keypad **124** defining a plurality of hard keys **126,** and a printed circuit board **106** including a plurality of key circuits to detect actuation of the plurality of hard keys. The method includes the following steps: receiving an indication of connection of a selected key circuit associated with a selected hard key **(112);** obtaining a measured capacitance level at a keyboard location near the selected hard key **(114);** comparing the measured capacitance level at the keyboard location to a key activation capacitance threshold (**116**); and identifying the key circuit connection as being associated with, or caused by, an intended hard key activation when the measured capacitance level exceeds the key activation capacitance threshold (**118**).

When a key event is received, an embodiment of the present application can obtain information regarding capacitance values when a key is pressed. For example, in response to a detected key circuit connection, a matrix of information at a snapshot in time can be provided, including capacitance information.

In optional step **120,** an input associated with the actuation of the selected hard key is processed, such as by sending the input to an active application.

If the comparison in step **116** determines that the measured capacitance level is not greater than the intended key activation threshold, the method proceeds in step **122** to identify the key circuit connection as being associated with, or caused by, an unintended key activation. In that case, the key circuit connection is ignored and no action is taken.

In an embodiment, the method includes the step of intercepting the key circuit connection before an associated input is passed to an active application. As such, the method includes a decision-making utility that sits between the applications and the hard key press to intercept the key and determine whether the key press was intended.

In an embodiment, a mobile device user is given the capability of turning off the measurement of capacitance and the associated determinations. For example, if the user is using gloves or mittens while activating keys, or not using fingers to activate the keys, this would not result in a capacitance change. In an example, an easily accessed way is provided to switch this feature on and off, such as by using a keyboard shortcut. In another example, if a plurality of successive determinations of an unintended key activation are made within a short time period, a popup message can appear on a display of the mobile device advising the user that the keypresses are not being interpreted as intended key activations.

Figure **3** illustrates an exploded view of elements of the mobile device **100** according to an embodiment of the present application including a capacitive sensor provided on a light shielding film. The elements include a keyboard **102** having a keypad **124** defining a plurality of keycaps **126,** a plurality of frets or decoration bars **128,** a printed circuit board **106,** and a light shielding capacitive sensing film **130.** Some known mobile devices include a light shielding film to prevent light leakage. In this embodiment, the light shielding capacitive sensing film **130** is provided, with both functions of back light shielding and identification of human finger pressing by way of capacitance detection.

The light shielding capacitive sensing film **130** can be designed using a capacitance sensitive film in order to provide both functions, and is an exemplary implementation of the capacitive sensor **104.** A connector **132** provides electrical connection between the light shielding capacitive sensing film **130** and the PCB **106.**

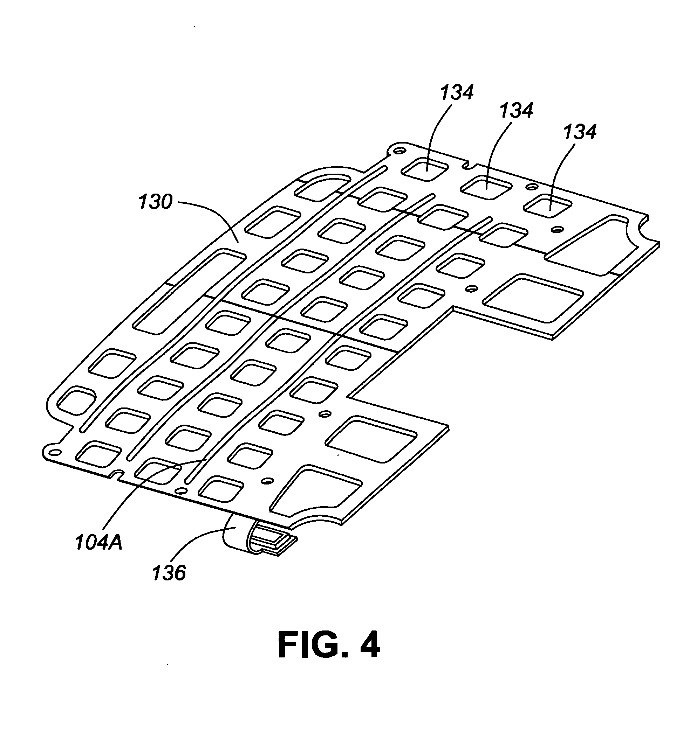

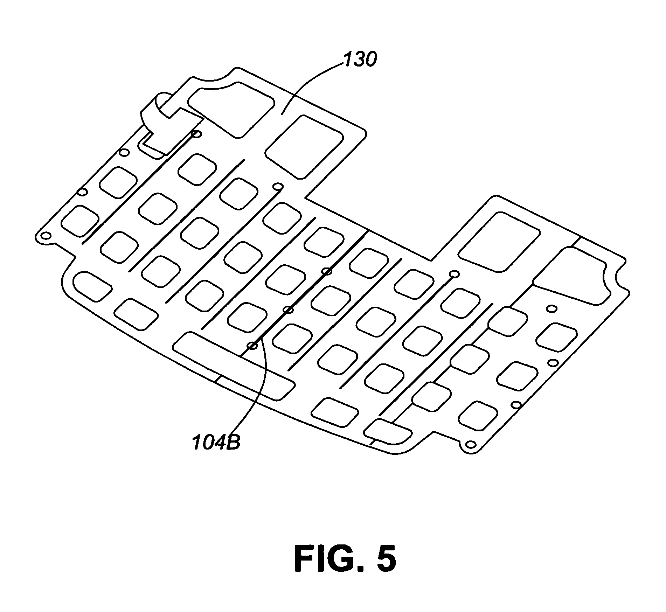

Figures **4** and **5** illustrate top and bottom views, respectively, of an embodiment of the light shielding capacitive sensing film **130** as shown in Figure **3****,** and further including a capacitive sensor **104,** shown as **104A** and **104B.** A typical light shielding capacitive sensing film **130** is implemented using a PET or other plastic material. According to an embodiment of the present application, the capacitive sensor **104** provided on the light sensing shield **130** is implemented by way of a conductive coating **104A** or **104B,** or both.

In an embodiment, the conductive coating can comprise two conductive coatings: an x-channel coating and a y-channel coating, which co-operate to form a matrix. As shown in Figure **4****,** the x-channel coating **104A** can be provided on a top, or keyboard-facing side, of the light shielding capacitive sensing film **130.** As shown in Figure **5****,** the y-channel coating **104B** can be provided on a bottom, or PCB-facing side, of the light shielding capacitive sensing film **130.** In a particular embodiment, the capacitive sensor **104** on the light shielding capacitive sensing film **130** has a number of x-channels **104A** and a number of y-channels **104B,** to determine the exact location of capacitive difference using a matrix. In another embodiment, the use of only a x-channel capacitive sensor **104A** can obtain a one dimensional location of the capacitive difference.

Such conductive coatings are newly introduced for use in conjunction with keyboard-based devices according to an embodiment of the present application. The conductive coating can be implemented as a layer of electrodes. The layer of electrodes can include a number of rows, or columns, of electrodes. For example, the x-channel coating **104A** in Figure **4** comprises a plurality of x-channel rows, while the y-channel coating **104B** in Figure **5** comprises a plurality of y-channel columns. The electrodes can be added to the light shield using a printing process. In an embodiment, electrodes can be placed in keypad areas that are frequently unintentionally activated, such as on the outer edges of the keypad **124.**

In an example embodiment, the light shielding capacitive sensing film **130** can include one or more of the following features. The film **130** can be located between the keyboard keycaps **126** (shown in Figure **3**) and a light guide, with the keycaps providing protection to the film **130** (to avoid wear off or damages to the film). The film can define a plurality of keycap stem apertures **134** (shown in Figure **4**) through which keycap stems can protrude for transmitting keycap pressing forces to keypad domes (not shown) on the PCB.

The film **130** can be designed having an opaque color, such as black, for light shielding. The bottom, or PCB-facing, surface of the film can be designed/painted with a white color for better reflection of the light back into the light guide.

The film **130** can be attached to the keypad light guide by adhesive or printed glue in selective area for better tactile feedback of the keys. The film can be electrically connected to the device main PCB **106** by way of the connector **132** as shown in Figure **3****.**

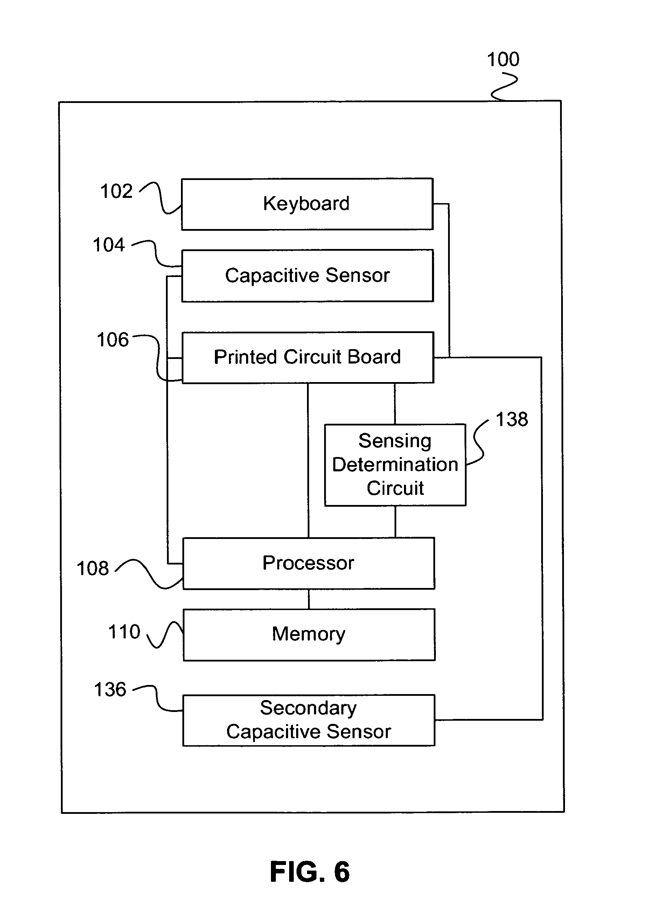

Figure **6** illustrates a block diagram of the mobile device **100** arranged to identify an intended key activation according to another embodiment of the present application. The block diagram of Figure **6** is similar to the block diagram of Figure **1**, with similar elements being represented with the same reference numerals. A secondary capacitive sensor **136** is provided in the mobile device of Figure **6** in order to obtain an additional capacitance measurement, to increase confidence in a detection of an intended key press. When the secondary capacitive sensor **136** is provided in the mobile device **100**, the capacitive sensor **104** can be referred to as the primary capacitive sensor. A secondary capacitance measurement taken at the secondary capacitive sensor **136** is intended to measure whether the mobile device **100** is being held or supported by a human hand or finger. This can advantageously remove uncertainty if the measured capacity at the keyboard location is slightly below or above the threshold.

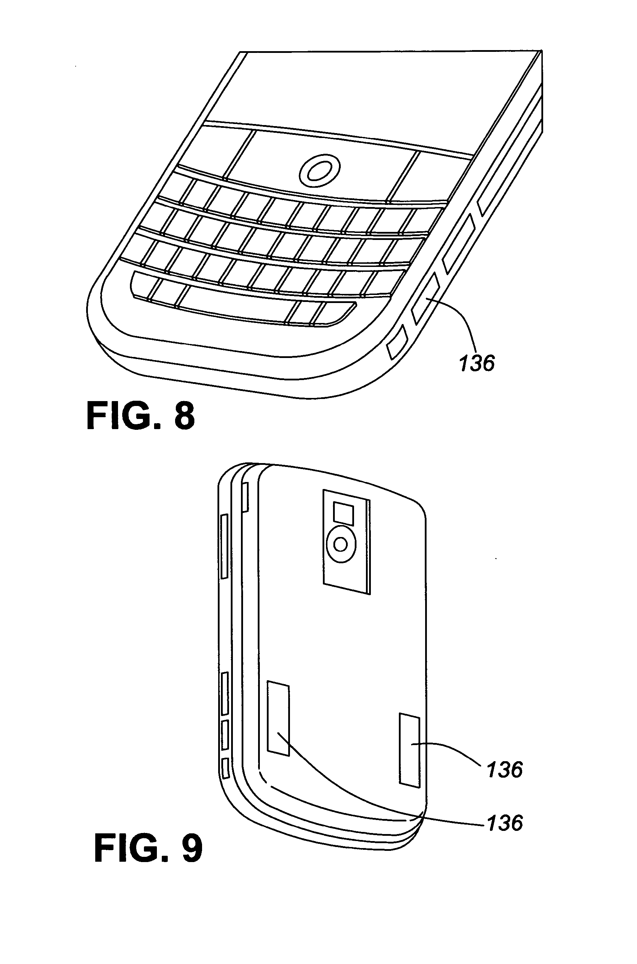

The secondary capacitive sensor **136** is provided at a non-keyboard location on the mobile device. In an embodiment, the mobile device **100** can include a plurality of secondary capacitive sensors **136.** For example, the secondary capacitive sensor **136** can be provided at one or more non-keyboard locations, including: on the back of a housing of the mobile device; on one or more sides or edges of the mobile device housing; on one or more side grips of the mobile device; on the battery door (Figures **8**-**11**). In another example, the secondary capacitive sensor **136** can be implemented as a capacitive sensor, a capacitive film, or a piece of metal.

A sensing determination circuit **138** is provided to detect whether the secondary capacitive sensor **136** has had touch contact with human hand/fingers. This detection can be made based on a voltage change on the sensing determination circuit. The sensing determination circuit **138** can be provided in electrical communication with the PCB **106** and the secondary capacitive sensor **136.** Alternatively, the sensing determination circuit **138** can be provided as part of the PCB **106,** or as part of the processor **108** to perform the sensing determination.

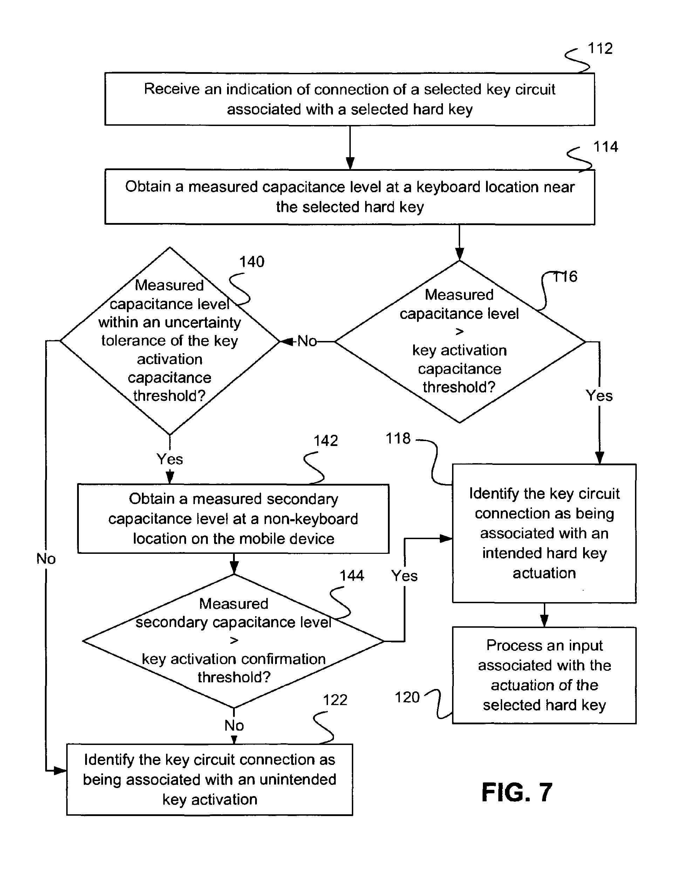

Figure **7** is a flowchart illustrating a method of identifying an intended key activation on the mobile device according to another embodiment of the present application. The method in Figure **7** is similar to the method shown in Figure **2****,** with additional steps and some different flows. After step **116**, a determination is made in step **140** as to whether the measured capacitance level is within an uncertainty tolerance of the key activation capacitance threshold. If not, the method proceeds to step **122** to identify the key circuit connection as being associated with an unintended key activation.

If yes, the method proceeds in step **142** to obtain a measured secondary capacitance level at non-keyboard location of the mobile device, such as at or near an outer surface of a housing of the mobile device. In step **144**, the measured secondary capacitance level at the non-keyboard location is compared to a key activation confirmation threshold. If the measured secondary capacitance level exceeds the key activation confirmation threshold, then the method proceeds to step **118** and identifies the key circuit connection as being associated with an intended hard key activation.

The key activation confirmation threshold used in relation to the secondary capacitance level is different from the key activation capacitance threshold used in relation to the capacitance level obtained at a keyboard location.

Therefore, the secondary capacitive sensor(s) **136** provide added reliability, and improved confidence, to the determination made using the primary capacitive sensor **104** located at the front keypad. If the value received on the front or primary capacitive sensor **104** is in a "grey" zone, where the sensed value is below the key activation capacitance threshold, the secondary (side/back) sensors **136** can be used to increase the confidence in detecting whether it is an intended keypress. If there is a "yes" detection on the front and no detection on the side, this is still a valid keypress. If there is a "maybe" detection on the front, then defer to side/back sensing result to resolve ambiguity, as described above in relation to Figure **7****.**

In another embodiment, the method can include a further step (not shown) of obtaining a secondary indicator to assist in identifying an intended hard key activation based on a detected capacitance level, in addition to determining whether the keypad exceeds a key activation capacitance threshold. In an embodiment, the step of obtaining the secondary indicator can be performed after step **116** in Figure **7****.** In another embodiment, the step of obtaining the secondary indicator can be performed instead of, before, or after step **140** and its associated subsequent steps.

For example, to distinguish fingers and unintended keys from other objects, as part of obtaining the secondary indicator, the processor **108** can detect the shape or pattern of the area of capacitive contact and determine if it is consistent with an area of contact resulting from human input. A library of human input contact areas can be stored in the computer readable memory **110.** The comparison can be based on one or more parameters associated with the area of capacitive contact, including shape and size, to distinguish an unintended key activation from an intended key press.

The secondary indicator can include an indication of where else on the keyboard the increased capacitance is sensed. As described earlier, the method can correlate the capacitance to the location of the key that was pressed, making sure that they indicate a causal relationship.

In the case of rapid typing on a mobile device keyboard, the capacitive sensor **104** will sense fast movement of capacitance changes and key circuit connections. Embodiments of the present application advantageously analyze a key press taking into account timing information. The gate logic on whether to let the key event go through or not, would preferably have a time sensitivity. In an embodiment, it could be an instantaneous check of the capacitance. For rapid typing, an accumulator can be included that then decays off.

The secondary indicator can be obtained from a source other than the detected capacitance level, or parameters relating thereto. For example, a detection of an active application can be used to further determine whether a key activation is intended. For instance, if an email application is open, and if a message is being composed, this information can be used to increase confidence in response to a capacitance detection that is within an uncertainty tolerance of a key activation capacitance threshold.

In another example, a current device state can be used as a secondary indicator. For example, if the device state is "incoming call received", then the expected key presses are limited to certain keys, namely the keys that are assigned to answer or ignore the call. If a received key circuit connection is associated with a key that is not one of the frequently accessed keys associated with the current device state, this can be used to determine that the key press was unintended.

Figures **8**, **9**, **10** and **11** illustrate a mobile device including secondary capacitive sensors **136** according to an embodiment of the present application.

In the embodiments of Figure **8** and **9**, the secondary capacitive sensor **136** is provided as one or more conductive pads, such as exposed metal pads, connected to the main PCB. Figure **8** shows the non-keyboard location for the secondary capacitive sensor **136** as being on a side grip of the mobile device. Figure **9** shows the non-keyboard location for the two secondary capacitive sensors **136** as being on a rear face of the housing. In these embodiments, the PCB can include a sensing determination circuit **138** (shown in Figure **6**) to detect whether the pad(s) were touched by human hand/fingers. This detection can be made based on a resistance change on the sensing determination circuit. Alternatively, the processor can be arranged to perform the sensing determination.

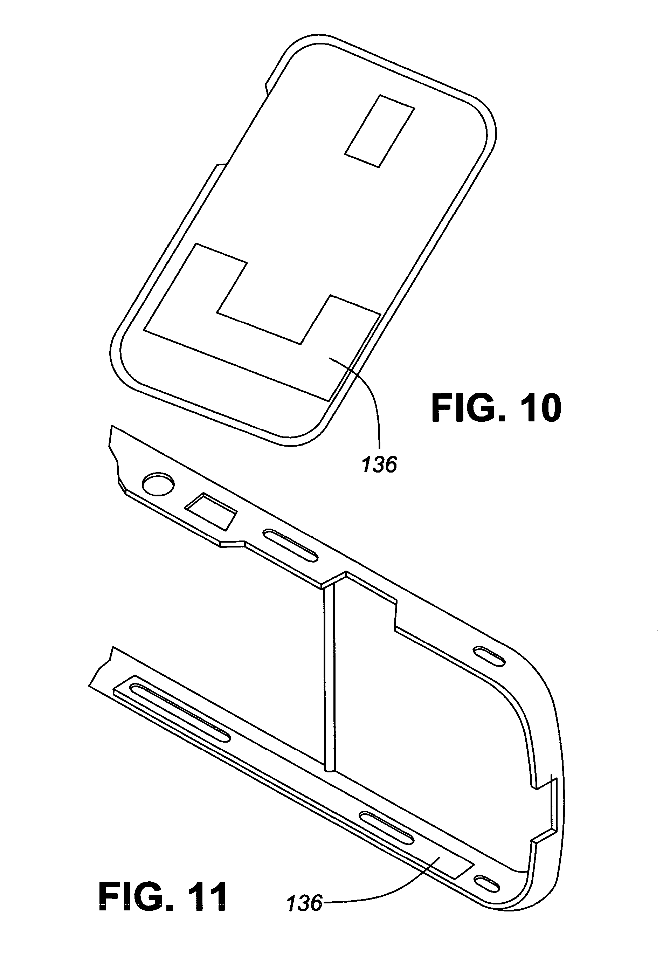

In the embodiment of Figure **10**, the secondary capacitive sensor **136** is provided as one or more flexible secondary PCBs or capacitive sensor films which are placed on the housing surface or on the inner surface of the rear face of the housing (and/or battery door and/or side grips). The flexible secondary PCB can be electrically connected to main PCB, or to a separate circuit board in the mobile device. In this embodiment, the main PCB includes a sensing determination circuit **138** (shown in Figure 6) to detect the capacitance changes on the capacitor which is formed by the flexible secondary PCB and a human hand/palm. Alternatively, the processor can be arranged to perform the sensing determination.

In the embodiment of Figure **11**, the secondary capacitive sensor **136** is provided as one or more flexible PCBs or pieces of capacitive sensor film, placed on the housing surface or on the inner surface of the rear face of the housing (and/or battery door and/or side grips). In another embodiment, the flexible PCB or capacitive sensor film can be embedded, or co-molded, into the rear housing or the battery door. The flexible PCB/capacitive sensor film can be electrically connected to the main PCB, or to a separate circuit board in the mobile device. In this embodiment, the main PCB includes a sensing determination circuit **138** (shown in Figure **6**) to detect the capacitance changes when a human hand/palm holds the device. Alternatively, the processor can be arranged to perform the sensing determination.

Some users employ a form-fitting protector, also known as a "skin", for their mobile device. In contrast to a holster or case, the skin is not typically removed, but is kept on the mobile device at all times. The use of a form-fitting mobile device protector may impede the detection of a human hand touching the mobile device, if the protector is thick enough. Therefore, in an embodiment (not shown), a form-fitting mobile device protector can include a remote secondary capacitive sensor, in communication with the secondary capacitive sensor on the mobile device, to transmit a sensed capacitance value on an exterior surface of the protector.

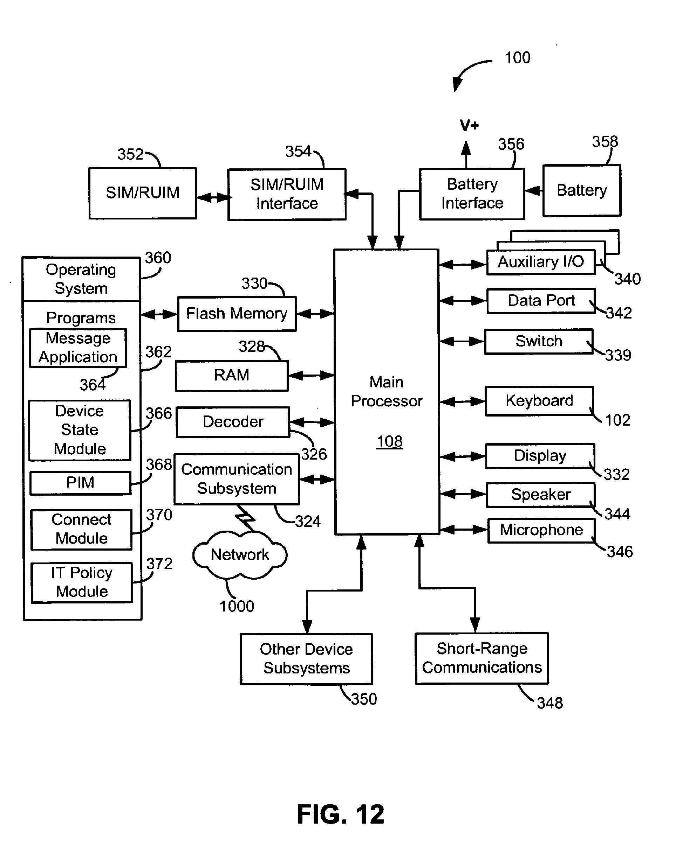

Figure **12** is a block diagram of the mobile electronic device according to one example. The following describes in further detail an exemplary mobile electronic device that can include a processor, and a computer readable memory in communication with the processor. In an embodiment, the memory can store statements and instructions for execution by the processor to identify an intended hard key activation in response to receiving an indication of connection of a key circuit and based on one or more detected capacitance levels, as described and illustrated in the present application. The mobile electronic device may be a two-way communication device with advanced data communication capabilities including the capability to communicate with other mobile electronic devices or computer systems through a network of transceiver stations. The mobile electronic device may also have the capability to allow voice communication. Depending on the functionality provided by the mobile electronic device, it may be referred to as a data messaging device, a two-way pager, a cellular telephone with data messaging capabilities, a wireless Internet appliance, or a data communication device (with or without telephony capabilities). The mobile electronic device may also be a mobile electronic device without wireless communication capabilities as a handheld electronic game device, digital photograph album, digital camera and the like.

Referring to Fig. **12**, there is shown therein a block diagram of an exemplary embodiment of the mobile electronic device **100.** The mobile electronic device **100** includes a number of components such as a processor **108** that controls the overall operation of the mobile electronic device **100.** Communication functions, including data and voice communications, are performed through a communication subsystem **324.** Data received by the mobile electronic device **100** can be decompressed and decrypted by a decoder **326**, operating according to any suitable decompression techniques (e.g. YK decompression, and other known techniques) and encryption techniques (e.g. using an encryption technique such as Data Encryption Standard (DES), Triple DES, or Advanced Encryption Standard (AES)). The communication subsystem **324** receives messages from and sends messages to a wireless network **1000.** In this exemplary embodiment of the mobile electronic device **100**, the communication subsystem **324** is configured in accordance with the Global System for Mobile Communication (GSM) and General Packet Radio Services (GPRS) standards. The GSM/GPRS wireless network is used worldwide. New standards such as Enhanced Data GSM Environment (EDGE) and Universal Mobile Telecommunications Service (UMTS) are believed to have similarities to the network behavior described herein, and it will also be understood by persons skilled in the art that the embodiments described herein are intended to use any other suitable standards that are developed in the future. The wireless link connecting the communication subsystem **324** with the wireless network **1000** represents one or more different Radio Frequency (RF) channels, operating according to defined protocols specified for GSM/GPRS communications. With newer network protocols, these channels are capable of supporting both circuit switched voice communications and packet switched data communications.

Although the wireless network **1000** associated with the mobile electronic device **100** is a GSM/GPRS wireless network in one exemplary implementation, other wireless networks may also be associated with the mobile electronic device **100** in variant implementations. The different types of wireless networks that may be employed include, for example, data-centric wireless networks, voice-centric wireless networks, and dual-mode networks that can support both voice and data communications over the same physical base stations. Combined dual-mode networks include, but are not limited to, Code Division Multiple Access (CDMA) or CDMA1000 networks, GSM/GPRS networks (as mentioned above), and future third-generation (3G) networks like EDGE and UMTS. Some other examples of data-centric networks include WiFi 802.11, Mobitex™ and DataTAC™ network communication systems. Examples of other voice-centric data networks include Personal Communication Systems (PCS) networks like GSM and Time Division Multiple Access (TDMA) systems. The processor **108** also interacts with additional subsystems such as a Random Access Memory (RAM) **328,** a flash memory **330,** a display **332**, the keyboard **102**, a switch **339,** an auxiliary input/output (I/O) subsystem **340,** a data port **342,** a speaker **344,** a microphone **346,** short-range communications **348,** and other device subsystems **350.** The flash memory **330** and RAM **328** are examples of a computer readable memory in communication with the processor **108.** The memory can store statements and instructions for execution by the processor to perform the method of identifying an intended hard key activation in response to receiving an indication of connection of a key circuit and based on one or more detected capacitance levels, as described and illustrated in the present application

Some of the subsystems of the mobile electronic device **100** perform communication-related functions, whereas other subsystems may provide "resident" or on-device functions. By way of example, the keyboard **102** may be used for both communication-related functions, such as entering a text message for transmission over the network **1000,** and device-resident functions such as a calculator or task list.

The mobile electronic device **100** can send and receive communication signals over the wireless network **1000** after network registration or activation procedures have been completed. Network access is associated with a subscriber or user of the mobile electronic device **100.** To identify a subscriber according to the present embodiment, the mobile electronic device **100** uses a SIM/RUIM card **352** (i.e. Subscriber Identity Module or a Removable User Identity Module) inserted into a SIM/RUIM interface **354** for communication with a network such as the network **1000.** The SIM/RUIM card **352** is one type of a conventional "smart card" that can be used to identify a subscriber of the mobile electronic device **100** and to personalize the mobile electronic device **100,** among other things. In the present embodiment the mobile electronic device **100** is not fully operational for communication with the wireless network **1000** without the SIM/RUIM card **352.** By inserting the SIM/RUIM card **352** into the SIM/RUIM interface **354,** a subscriber can access all subscribed services. Services may include: web browsing and messaging such as e-mail, voice mail, Short Message Service (SMS), and Multimedia Messaging Services (MMS). More advanced services may include: point of sale, field service and sales force automation. The SIM/RUIM card **352** includes a processor and memory for storing information. Once the SIM/RUIM card **352** is inserted into the SIM/RUIM interface **354,** it is coupled to the processor **108.** In order to identify the subscriber, the SIM/RUIM card **352** can include some user parameters such as an International Mobile Subscriber Identity (IMSI). An advantage of using the SIM/RUIM card **352** is that a subscriber is not necessarily bound by any single physical mobile electronic device. The SIM/RUIM card **352** may store additional subscriber information for a mobile electronic device as well, including datebook (or calendar) information and recent call information. Alternatively, user identification information can also be programmed into the flash memory **330.** The mobile electronic device **100** can also be enabled to receive additional memory cards. For example, memory card slots (not shown) can be provided in the mobile electronic device **100** to receive such cards.

The mobile electronic device **100** is a battery-powered device and includes a battery interface **356** for receiving a battery pack containing one or more rechargeable battery cells **358,** and associated control circuitry (not shown) that, in some embodiments, can interface with the battery interface **356.** The battery pack has a form factor and contact arrangement suited to the particular mobile electronic device. In at least some embodiments, the battery **358** can be a smart battery with an embedded microprocessor. The battery interface **356** is coupled to a regulator (not shown), which assists the battery **358** in providing power V+ to the mobile electronic device **100.** Although current technology makes use of a battery, future technologies such as micro fuel cells may provide the power to the mobile electronic device **100.**

The mobile electronic device **100** also includes an operating system **360** and software components **362** which are described in more detail below. The operating system **360** and the software components **362** that are executed by the processor **108** are typically stored in a persistent store such as the flash memory **330,** which may alternatively be a read-only memory (ROM) or similar storage element (not shown). Those skilled in the art will appreciate that portions of the operating system **360** and the software components **362,** such as specific software applications **364, 366, 368, 370** and **372,** or parts thereof, may be temporarily loaded into a volatile store such as the RAM **328.** Other software components can also be included, as is well known to those skilled in the art.

The subset of software components **362** that control basic device operations, including data and voice communication applications, will normally be installed on the mobile electronic device **320** during its manufacture. Other software applications include a message application **364** that can be any suitable software program that allows a user of the mobile electronic device **100** to send and receive electronic messages. Various alternatives exist for the message application **364** as is well known to those skilled in the art. Messages that have been sent or received by the user are typically stored in the flash memory **330** of the mobile electronic device **100** or some other suitable storage element in the mobile electronic device **100.** In at least some embodiments, some of the sent and received messages may be stored remotely from the device **100** such as in a data store of an associated host system that the mobile electronic device **100** communicates with.

The software components **362** can further include a device state module 366, a Personal Information Manager (PIM) **368,** and other suitable modules (not shown). The device state module **366** provides persistence, i.e. the device state module **366** ensures that important device data is stored in persistent memory, such as the flash memory **330,** so that the data is not lost when the mobile electronic device **100** is turned off or loses power.

The PIM **368** includes functionality for organizing and managing data items of interest to the user, such as, but not limited to, e-mail, contacts, calendar events, voice mails, appointments, and task items. The PIM **368** has the ability to send and receive data items via the wireless network **1000.** PIM data items may be seamlessly integrated, synchronized, and updated via the wireless network **1000** with the mobile electronic device subscriber's corresponding data items stored or associated, or both, with a host computer system. This functionality creates a mirrored host computer on the mobile electronic device **330** with respect to such items. This can be particularly advantageous when the host computer system is the mobile electronic device subscriber's office computer system.

The software components **362** also include a connect module **370,** and an information technology (IT) policy module **372.** The connect module **370** implements the communication protocols that are required for the mobile electronic device **100** to communicate with the wireless infrastructure and any host system, such as an enterprise system, that the mobile electronic device **100** is authorized to interface with.

The connect module **370** includes a set of APIs that can be integrated with the mobile electronic device **100** to allow the mobile electronic device **100** to use any number of services associated with the enterprise system. The connect module **370** allows the mobile electronic device **100** to establish an end-to-end secure, authenticated communication pipe with the host system. A subset of applications for which access is provided by the connect module **370** can be used to pass IT policy commands from the host system to the mobile electronic device **100.** This can be done in a wireless or wired manner. These instructions can then be passed to the IT policy module **372** to modify the configuration of the device **100.** Alternatively, in some cases, the IT policy update can also be done over a wired connection.

Other types of software applications can also be installed on the mobile electronic device **100.** These software applications can be third party applications, which are added after the manufacture of the mobile electronic device **100.** Examples of third party applications include games, calculators, utilities, etc.

The additional applications can be loaded onto the mobile electronic device **100** through at least one of the wireless network 1000, the auxiliary I/O subsystem **340,** the data port **342,** the short-range communications subsystem **248,** or any other suitable device subsystem **350.** This flexibility in application installation increases the functionality of the mobile electronic device **100** and may provide enhanced on-device functions, communication-related functions, or both. For example, secure communication applications may enable electronic commerce functions and other such financial transactions to be performed using the mobile electronic device **100.**

The data port **342** enables a subscriber to set preferences through an external device or software application and extends the capabilities of the mobile electronic device **100** by providing for information or software downloads to the mobile electronic device **100** other than through a wireless communication network. The alternate download path may, for example, be used to load an encryption key onto the mobile electronic device **100** through a direct and thus reliable and trusted connection to provide secure device communication.

The data port **342** can be any suitable port that enables data communication between the mobile electronic device **100** and another computing device. The data port **342** can be a serial or a parallel port. In some instances, the data port **342** can be a USB port that includes data lines for data transfer and a supply line that can provide a charging current to charge the battery **358** of the mobile electronic device **100.**

The short-range communications subsystem **348** provides for communication between the mobile electronic device **100** and different systems or devices, without the use of the wireless network **1000.** For example, the short-range communications subsystem **348** may include an infrared device and associated circuits and components for short-range communication. Examples of short-range communication standards include standards developed by the Infrared Data Association (IrDA), Bluetooth, and the 802.11 family of standards developed by IEEE.

Synchronization of files and data between the mobile electronic device 100 and another computing device can be achieved over the wireless network **1000,** through the short-range communications system **348,** or through a direct connection between the data port **342** of the mobile electronic device **100** and the other computing device. Synchronization causes the most recent version of files and data to be mirrored on either the mobile electronic device or the other computing device. As used herein, synchronization also refers to the downloading or uploading of pre-selected files from one device to the other. Synchronization of files and data can be initiated by the user of the device whenever a suitable connection between the mobile electronic device **100** and another computing device, such as a home computer, is detected, or can occur automatically when a connection is detected. A synchronization application, stored in the mobile electronic device **100** or the other computing device, or both, can determine the file and data types to be synchronized, the frequency of synchronization, and other parameters, appropriate to the particular synchronization algorithm implemented by the synchronization application.

In use, a received signal such as a text message, an e-mail message, or web page download is processed by the communication subsystem **324** and input to the processor **108.** The processor **108** then processes the received signal for output to the display **332** or alternatively to the auxiliary I/O subsystem **340.** A subscriber may also compose data items, such as e-mail messages, for example, using a touch-sensitive overlay (not shown) on the display **332** that is part of a touch screen display, and possibly the auxiliary I/O subsystem **340.** The auxiliary I/O subsystem **340** may include devices such as: a mouse, track ball, optical navigation module, infrared fingerprint detector, or a roller wheel with dynamic button pressing capability. A composed item may be transmitted over the wireless network **1000** through the communication subsystem **324.**

For voice communications, the overall operation of the mobile electronic device **100** is substantially similar, except that the received signals are output to the speaker **344**, and signals for transmission are generated by the microphone **346.** Alternative voice or audio I/O subsystems, such as a voice message recording subsystem, can also be implemented on the mobile electronic device **100** Although voice or audio signal output is accomplished primarily through the speaker **344,** the display **332** can also be used to provide additional information such as the identity of a calling party, duration of a voice call, or other voice call related information.

In the preceding description, for purposes of explanation, numerous details are set forth in order to provide a thorough understanding of the embodiments described herein. However, it will be apparent to one skilled in the art that these specific details are not required in order to practice the embodiments. In other instances, well-known electrical structures and circuits are shown in block diagram form in order not to obscure the embodiments. For example, specific details are not provided as to whether the embodiments described herein are implemented as a software routine, hardware circuit, firmware, or a combination thereof.

Embodiments described herein can be represented as a software product stored in a machine-readable medium (also referred to as a computer-readable medium, a processor-readable medium, or a computer usable medium having a computer-readable program code embodied therein). The machine-readable medium can be any suitable tangible medium, including magnetic, optical, or electrical storage medium including a diskette, compact disk read only memory (CD-ROM), memory device (volatile or nonvolatile), or similar storage mechanism. The machine-readable medium can contain various sets of instructions, code sequences, configuration information, or other data, which, when executed, cause a processor to perform steps in a method according to an embodiment described herein. Those of ordinary skill in the art will appreciate that other instructions and operations necessary to implement the described embodiments can also be stored on the machine-readable medium. Software running from the machine-readable medium can interface with circuitry to perform the described tasks.

The above-described embodiments are intended to be examples only. Alterations, modifications and variations can be effected to the particular embodiments by those of skill in the art without departing from the scope, which is defined solely by the claims appended hereto.

## Claims

1. A mobile device (100), comprising:
a keyboard (102) comprising a keypad (124) defining a plurality of hard keys (126);
a printed circuit board 'PCB' (106) comprising a plurality of key circuits configured to detect actuation of the plurality of hard keys;
a capacitive sensor (104) provided between the keypad and the printed circuit board and arranged to detect a primary capacitance level on the keypad;
a secondary capacitive sensor (136) disposed at a non-keyboard location on the mobile device and arranged to detect a secondary capacitance level at the non-keyboard location; and
a processor (108) arranged to compare the measured secondary capacitance level at the non-keyboard location to a key activation confirmation threshold in response to receiving an indication of connection of one of the plurality of key circuits, and to identify the key circuit connection as being a result of an intended hard key activation when the measured secondary capacitance level exceeds the key activation confirmation threshold, and when the measured primary capacitance level is within an uncertainty tolerance below a key activation capacitance threshold.

2. The mobile device of claim 1 further comprising a light shielding capacitive sensing film (130) providing back light shielding and capacitance detection, the capacitive sensor (104) being provided on a surface of the light shielding capacitive sensing film.

3. The mobile device of claim 2 wherein the capacitive sensor (104) provided on the light shielding capacitive sensing film is implemented by way of a conductive coating (104A, 104B).

4. The mobile device of claim 3 wherein the conductive coating comprises an x-channel coating (104A) provided on one side of the light shielding capacitive sensing film, and a y-channel coating (1 04B) provided on another side of the light shielding capacitive sensing film.

5. The mobile device of claim 4 wherein the x-channel coating (1 04A) is provided on a keyboard-facing side of the light shielding capacitive sensing film, and the y-channel coating (104B) is provided on a PCB-facing side of the light shielding capacitive sensing film.

6. The mobile device of any preceding claim wherein the intended hard key activation comprises an intended human hard key activation by human touch,
wherein the key activation capacitance threshold comprises a human key activation capacitance threshold associated with actuation of a hard key by human touch, and
wherein the processor (108) is arranged to distinguish between the intended human hard key activation and abutment with an object when the detected capacitance level on the keypad exceeds the human key activation capacitance threshold.

7. The mobile device of any preceding claim wherein the key activation capacitance threshold is 2 pico Farads greater than a base capacitance, the base capacitance being measured in the absence of actuation of one of the plurality of hard keys by human skin.

8. A method of identifying an intended hard key actuation on a mobile device, the mobile device having a keyboard including a keypad defining a plurality of hard keys, and a printed circuit board including a plurality of key circuits configured to detect actuation of the plurality of hard keys, the method comprising the steps of:
receiving an indication of connection of a selected one of the plurality of key circuits configured to detect actuation of a selected one of the plurality of hard keys (112);
obtaining a measured primary capacitance level at a keyboard location near the selected hard key (114);
comparing the measured primary capacitance level at the keyboard location to a key activation capacitance threshold (116); and
obtaining a measured secondary capacitance level at a non-keyboard location of the mobile device (142);
comparing the measured secondary capacitance level at the non-keyboard location to a key activation confirmation threshold (144), the key activation confirmation threshold (144) being distinct from the key activation capacitance threshold; and
identifying the key circuit connection as being a result of an intended hard key activation when the measured secondary capacitance level exceeds the key activation confirmation threshold (118) and the measured capacitance level at the keyboard location is within an uncertainty tolerance below a key activation capacitance threshold.

9. The method of claim 8 further comprising the step of intercepting the key circuit connection before an associated input is passed to an active application.

10. The method of claim 8 or claim 9 further comprising the step of processing an input associated with the actuation of the selected hard key (120).

11. The method of any one of claims 8 to 10 further comprising the step of distinguishing between an intended human hard key actuation by human touch and abutment with an object,
wherein the step of comparing comprises comparing the measured capacitance level at the keyboard location to a human key activation capacitance threshold (116) associated with actuation of a hard key by human touch; and
wherein the step of identifying employs the human key activation capacitance threshold.

12. A computer-readable medium storing instructions executable by a processor to perform the steps of the method of identifying an intended hard key actuation on a mobile device according to any one of claims 8 to 11.

## Patentansprüche

1. Eine mobile Vorrichtung (100), die aufweist:
eine Tastatur (102), die ein Tastenfeld (124) aufweist, das eine Vielzahl von Hardkeys bzw. festen Tasten (126) definiert;
eine Leiterplatte (PCB - printed circuit board) (106), die eine Vielzahl von Tasten-Schaltungen aufweist, die konfiguriert sind, eine Betätigung der Vielzahl von Hardkeys zu erfassen;
einen kapazitiven Sensor (104), der zwischen dem Tastenfeld und der Leiterplatte vorgesehen ist und ausgebildet ist, einen primären Kapazitätspegel auf dem Tastenfeld zu erfassen;
einen sekundären kapazitiven Sensor (136), der an einer Nicht-Tastatur-Stelle auf der mobilen Vorrichtung angeordnet ist und ausgebildet ist, einen sekundären Kapazitätspegel an der Nicht-Tastatur-Stelle zu erfassen; und
einen Prozessor (108), der ausgebildet ist, den gemessenen sekundären Kapazitätspegel an der Nicht-Tastatur-Stelle mit einer Tastenaktivierungs-Bestätigungsschwelle zu vergleichen in Reaktion auf das Empfangen einer Anzeige einer Verbindung einer der Vielzahl von Tasten-Schaltungen, und die Tastenschaltungsverbindung als ein Ergebnis einer beabsichtigten Hardkey-Aktivierung zu identifizieren, wenn der gemessene sekundäre Kapazitätspegel die Tastenaktivierungs-Bestätigungsschwelle übersteigt,
und wenn der gemessene primäre Kapazitätspegel innerhalb einer Unsicherheitstoleranz unter einer Tastenaktivierungs-Kapazitätsschwelle liegt.

2. Die mobile Vorrichtung gemäß Anspruch 1, die weiter aufweist einen lichtabschirmenden kapazitiven Erfassungsfilm (130), der eine Hintergrundlichtabschirmung und Kapazitätserfassung vorsieht, wobei der kapazitive Sensor (104) auf einer Oberfläche des lichtabschirmenden kapazitiven Erfassungsfilms vorgesehen ist.

3. Die mobile Vorrichtung gemäß Anspruch 2, wobei der kapazitive Sensor (104), der auf dem lichtabschirmenden kapazitiven Erfassungsfilm vorgesehen ist, mittels einer leitenden Beschichtung (104A, 104B) implementiert ist.

4. Die mobile Vorrichtung gemäß Anspruch 3, wobei die leitende Beschichtung eine x-Kanal-Beschichtung (104A), die auf einer Seite des lichtabschirmenden kapazitiven Erfassungsfilms vorgesehen ist, und eine y-Kanal-Beschichtung (104B) aufweist, die auf einer anderen Seite des lichtabschirmenden kapazitiven Erfassungsfilms vorgesehen ist.

5. Die mobile Vorrichtung gemäß Anspruch 4, wobei die x-Kanal-Beschichtung (104A) auf einer der Tastatur zugewandten Seite des lichtabschirmenden kapazitiven Erfassungsfilms vorgesehen ist, und die y-Kanal-Beschichtung (104B) auf einer der Leiterplatte zugewandten Seite des lichtabschirmenden kapazitiven Erfassungsfilms vorgesehen ist.

6. Die mobile Vorrichtung gemäß einem vorhergehenden Anspruch, wobei die beabsichtigte Hardkey-Aktivierung eine beabsichtigte menschliche Hardkey-Aktivierung durch eine menschliche Berührung aufweist,
wobei die Tastenaktivierungs-Kapazitätsschwelle eine menschliche Tastenaktivierungs-Kapazitätsschwelle aufweist, die mit einer Betätigung eines Hardkeys durch eine menschliche Berührung assoziiert ist, und
wobei der Prozessor (108) ausgebildet ist, zwischen der beabsichtigten menschlichen Hardkey-Aktivierung und einem Anliegen an einem Objekt zu unterscheiden, wenn der erfasste Kapazitätspegel auf dem Tastenfeld die menschliche Tastenaktivierungs-Kapazitätsschwelle übersteigt.

7. Die mobile Vorrichtung gemäß einem vorhergehenden Anspruch, wobei die Tastenaktivierungs-Kapazitätsschwelle 2 pico Farad größer ist als eine Basiskapazität, wobei die Basiskapazität bei Fehlen einer Betätigung einer der Vielzahl von Hardkeys durch menschliche Haut gemessen wird.

8. Ein Verfahren zum Identifizieren einer beabsichtigten Hardkey-Betätigung auf einer mobilen Vorrichtung, wobei die mobile Vorrichtung eine Tastatur hat mit einem Tastenfeld, das eine Vielzahl von Hardkeys definiert, und eine Leiterplatte mit einer Vielzahl von Tasten-Schaltungen, die konfiguriert sind zum Erfassen einer Betätigung der Vielzahl von Hardkeys, wobei das Verfahren die Schritte aufweist:
Empfangen einer Anzeige einer Verbindung einer ausgewählten der Vielzahl von Tasten-Schaltungen, die konfiguriert ist, eine Betätigung einer ausgewählten der Vielzahl von Hardkeys (112) zu erfassen;
Erlangen eines gemessenen primären Kapazitätspegels an einer Tastatur-Stelle in der Nähe des ausgewählten Hardkeys (114),
Vergleichen des gemessenen primären Kapazitätspegels an der Tastatur-Stelle mit einer Tastenaktivierungs-Kapazitätsschwelle (116); und
Erlangen eines gemessenen sekundären Kapazitätspegels an einer Nicht-Tastatur-Stelle der mobilen Vorrichtung (142);
Vergleichen des gemessenen sekundären Kapazitätspegels an der Nicht-Tastatur-Stelle mit einer Tastenaktivierungs-Bestätigungsschwelle (144),
wobei die Tastenaktivierungs-Bestätigungsschwelle (144) von der Tastenaktivierungs-Kapazitätsschwelle verschieden ist; und
Identifizieren der Tasten-Schaltungsverbindung als ein Ergebnis einer beabsichtigten Hardkey-Aktivierung, wenn der gemessene sekundäre Kapazitätspegel die Tastenaktivierungs-Bestätigungsschwelle (118) übersteigt und der gemessene Kapazitätspegel an der Tastatur-Stelle innerhalb einer Unsicherheitstoleranz unter einer Tastenaktivierungs-Kapazitätsschwelle liegt.

9. Das Verfahren gemäß Anspruch 8, das weiter den Schritt aufweist eines Unterbrechens der Tasten-Schaltungs-Verbindung, bevor eine assoziierte Eingabe an eine aktive Anwendung geleitet wird.

10. Das Verfahren gemäß Anspruch 8 oder Anspruch 9, das weiter den Schritt aufweist eines Verarbeitens einer Eingabe, mit der Betätigung des ausgewählten Hardkeys (120) assoziiert ist.

11. Das Verfahren gemäß einem der Ansprüche 8 bis 10, das weiter den Schritt aufweist eines Unterscheidens zwischen einer beabsichtigten menschlichen Hardkey-Betätigung durch eine menschliche Berührung und einem Anliegen an einem Objekt,
wobei der Schritt des Vergleichens aufweist ein Vergleichen des gemessenen Kapazitätspegels an der Tastatur-Stelle mit einer menschlichen Tastenaktivierungs-Kapazitätsschwelle (116), die mit einer Betätigung eines Hardkeys durch eine menschliche Berührung assoziiert ist; und
wobei der Schritt des Identifizierens die menschliche Tastenaktivierungs-Kapazitätsschwelle einsetzt.

12. Ein computerlesbares Medium zum Speichern von Anweisungen, die durch einen Prozessor ausführbar sind, um die Schritte des Verfahrens zur Identifizierung einer beabsichtigten Hardkey-Betätigung auf einer mobilen Vorrichtung gemäß einem der Ansprüche 8 bis 11 durchzuführen.

## Revendications

1. Dispositif mobile (100), comprenant :
un clavier (102) comprenant un petit clavier (124) définissant une pluralité de touches physiques (126) ;
une carte de circuits imprimés "PCB" (106) comprenant une pluralité de circuits de touche configurés de façon à détecter l'actionnement de la pluralité de touches physiques ;
un capteur capacitif (104) disposé entre le petit clavier et la carte de circuits imprimés, et configuré de façon à détecter un niveau de capacité primaire sur le petit clavier ;
un capteur capacitif secondaire (136) disposé en un emplacement hors du clavier sur le dispositif mobile, et configuré de façon à détecter un niveau de capacité secondaire à l'emplacement hors du clavier ; et
un processeur (108) configuré de façon à comparer le niveau de capacité secondaire mesuré à l'emplacement hors du clavier à un seuil de confirmation d'actionnement de touche en réponse à la réception d'une indication de connexion de l'un de la pluralité de circuits de touche, et à identifier la connexion de circuit de touche comme étant le résultat d'un actionnement de touche physique volontaire lorsque le niveau de capacité secondaire mesuré dépasse le seuil de confirmation d'actionnement de touche, et lorsque le niveau de capacité primaire mesuré se trouve à l'intérieur d'une tolérance d'incertitude inférieure à un seuil de capacité d'actionnement de touche.

2. Dispositif mobile selon la revendication 1, comprenant de plus un film de détection capacitive de blindage vis-à-vis de la lumière (130) assurant un blindage vis-à-vis du rétro-éclairage et une détection de capacité, le capteur capacitif (140) étant disposé sur une surface du film de détection capacitive de blindage vis-à-vis de la lumière.

3. Dispositif mobile selon la revendication 2, dans lequel le capteur capacitif (104) disposé sur le film de détection capacitive de blindage vis-à-vis de la lumière est réalisé à l'aide d'un revêtement conducteur (104A, 104B).

4. Dispositif mobile selon la revendication 3, dans lequel le revêtement conducteur comprenant un revêtement de canal x (104A) disposé sur un côté du film de détection capacitive de blindage vis-à-vis de la lumière et un revêtement de canal y (104B) disposé sur un autre côté du film de détection capacitive de blindage vis-à-vis de la lumière.

5. Dispositif mobile selon la revendication 4, dans lequel le revêtement de canal x (104A) est disposé sur un côté dirigé vers le clavier du film de détection capacitive de blindage vis-à-vis de la lumière, et le revêtement de canal y (104B) est disposé sur un côté dirigé vers la carte de circuits imprimés du film de détection capacitive de blindage vis-à-vis de la lumière.

6. Dispositif mobile selon l'une quelconque des revendications précédentes, dans lequel l'actionnement de touche physique volontaire comprend un actionnement de touche physique humain volontaire par un toucher humain,
dans lequel le seuil de capacité d'actionnement de touche comprend un seuil de capacité d'actionnement de touche humain associé à l'actionnement d'une touche physique par un toucher humain, et
dans lequel le processeur (108) est configuré de façon à effectuer une distinction entre l'actionnement de touche physique humain volontaire et une butée contre un objet lorsque le niveau de capacité détecté sur le petit clavier dépasse le seuil de capacité d'actionnement de touche humain.

7. Dispositif mobile selon l'une quelconque des revendications précédentes, dans lequel le seuil de capacité d'actionnement de touche est supérieur de 2 picofarads à une capacité de base, la capacité de base étant mesurée en l'absence d'actionnement de l'une de la pluralité de touches physiques par la peau humaine.

8. Procédé d'identification d'un actionnement de touche physique volontaire sur un dispositif mobile, le dispositif mobile comportant un clavier comprenant un petit clavier définissant une pluralité de touches physiques, et une carte de circuits imprimés comprenant une pluralité de circuits de touche configurés de façon à détecter l'actionnement de la pluralité de touches physiques, le procédé comprenant les étapes consistant à :
recevoir une indication de connexion d'un circuit sélectionné de la pluralité de circuits de touche configurés de façon à détecter l'actionnement d'une touche sélectionnée de la pluralité de touches physiques (112) ;
obtenir un niveau de capacité primaire mesuré en un emplacement de clavier proche de la touche physique sélectionnée (114) ;
comparer le niveau de capacité primaire mesuré à l'emplacement de clavier à un seuil de capacité d'actionnement de touche (116) ; et
obtenir un niveau de capacité secondaire mesuré en un emplacement hors du clavier du dispositif mobile (142) ;
comparer le niveau de capacité secondaire mesuré à l'emplacement hors du clavier à un seuil de confirmation d'actionnement de touche (144), le seuil de confirmation d'actionnement de touche (144) étant distinct du seuil de capacité d'actionnement de touche ; et
identifier la connexion de circuit de touche comme étant le résultat d'un actionnement de touche physique volontaire lorsque le niveau de capacité secondaire mesuré dépasse le seuil de confirmation d'actionnement de touche (118) et que le niveau de capacité mesuré à l'emplacement de clavier se trouve à l'intérieur d'une tolérance d'incertitude inférieure à un seuil de capacité d'actionnement de touche.

9. Procédé selon la revendication 8, comprenant de plus l'étape d'interception de la connexion de circuit de touche avant qu'une entrée associée ne soit transmise à une application active.

10. Procédé selon la revendication 8 ou la revendication 9, comprenant de plus l'étape de traitement d'une entrée associée à l'actionnement de la touche physique sélectionnée (120).

11. Procédé selon l'une quelconque des revendications 8 à 10, comprenant de plus l'étape de distinction entre un actionnement de touche physique humain volontaire par un toucher humain et une butée contre un objet,
dans lequel l'étape de comparaison comprend la comparaison du niveau de capacité mesuré à l'emplacement de clavier à un seuil de capacité d'actionnement de touche humain (116) associé à l'actionnement d'une touche physique par un toucher humain ; et
dans lequel l'étape d'identification emploie le seuil de capacité d'actionnement de touche humain.

12. Support lisible par un ordinateur mémorisant des instructions exécutables par un processeur pour exécuter les étapes du procédé d'identification d'un actionnement de touche physique volontaire sur un dispositif mobile selon l'une quelconque des revendications 8 à 11.
